# FASCICULE DE BREVET EUROPEEN

(11) **EP 1 799 465 B1**
(45) Date de publication et mention de la délivrance du brevet: **10.09.2008**
(21) Numéro de dépôt: 05807263.8
(22) Date de dépôt: 05.10.2005
(51) Int. Cl.: B41N 6/02

(54) **RUBAN TRANSPARENT POUR PLAQUES PHOTOPOLYMERES**
TRANSPARENTES BAND FÜR FOTOPOLYMERPLATTEN
TRANSPARENT TAPE FOR PHOTOPOLYMER PLATES

(30) Priorité: 05.10.2004 FR 0452270
(43) Date de publication de la demande: 27.06.2007
(73) Titulaire: SCAPA FRANCE, 01200 Bellegarde sur Valserine (FR)
(72) Inventeur: MESNIL, Benoît, F-26320 Saint-Marcel-Les-Valence (FR); GRAPOTTE, David, F-26500 Bourg-Les-Valence (FR)
(74) Mandataire: Bredema
(86) Numéro de dépôt international: PCT/FR2005/002443
(87) Numéro de publication internationale: WO 2006/037892

(56) Documents cités:
- US-A- 3 210 187
- US-A- 4 871 631
- US-A- 5 753 414

## Description

La présente invention se rapporte au domaine des plaques photopolymères.

La présente invention concerne plus particulièrement un ruban adhésif transparent multicouches composé d'un film plastique, d'une couche adhésive sensible à la pression et d'un film protecteur de la couche adhésive enlevable ou anti-adhérent.

L'invention concerne également un procédé de préparation d'une plaque photopolymère à partir de ce ruban et un procédé de montage d'une telle plaque photopolymère sur le support d'impression.

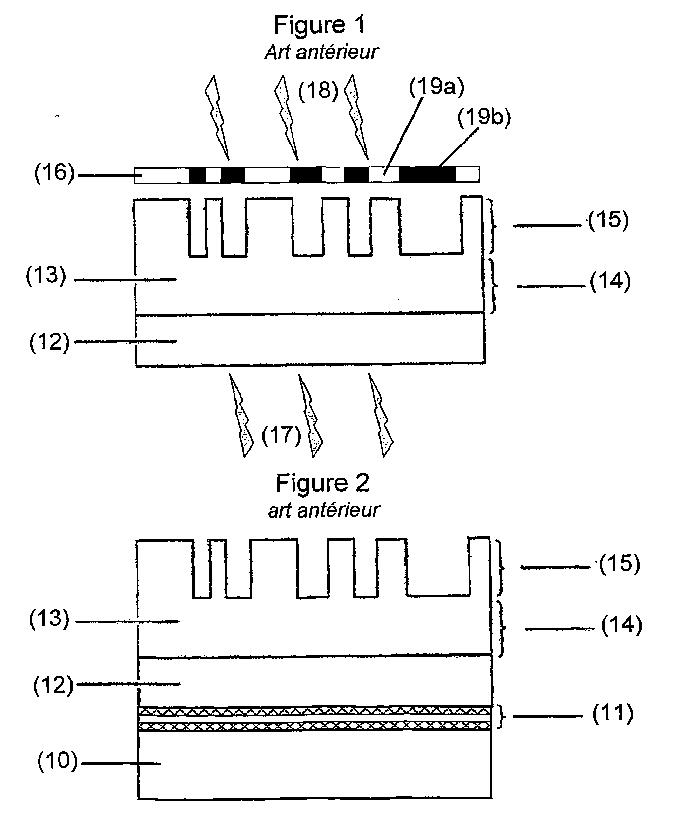

Les procédés d'impression par flexographie sur rotative utilisent des formes imprimantes élastiques et en relief. Ces formes sont illustrées par les figures 1 et 2. Ces formes sont composées d'une couche élastomérique (13) et d'une couche support stable dimensionnellement (12) (c'est-à-dire suffisamment rigide pour ne pas s'étendre et se déformer de façon durable afin de conserver une couche support plane et suffisamment flexible pour permettre les manipulations, par exemple le stockage sous forme de rouleaux, sans provoquer d'altération de la couche). La couche élastomérique (13) peut être en caoutchouc, mais la technologie dominante est l'utilisation de photopolymères liquides ou solides. Dans ce dernier cas, la forme imprimante est alors appelée plaque d'impression photopolymère.

Le procédé d'impression est relativement simple, une chambre à racle transfère d'un réservoir d'encre sur un rouleau encreur (ANILOX) une quantité déterminée d'encre. Le rouleau encreur vient déposer ensuite cette quantité précise d'encre sur les reliefs de la plaque photopolymère (15). Cette plaque, préalablement fixée sur le support d'impression (10) par un adhésif (11), vient ensuite transférer l'encre sur le support à imprimer.

Ces plaques photopolymères flexographiques sont réalisées grâce à un procédé photomécanique. Le modèle ou dessin à imprimer est réalisé, par exemple à l'aide de moyens informatiques, puis on en tire un négatif photographique. Lors d'une pré-étape, la plaque photopolymère (1) est irradiée avec des ultraviolets UV (17) par le dessous (face dorsale) afin de constituer une couche de base ou semelle (14) de consolidation entre la couche support (12) et la résine de la couche photopolymère (13). Cette semelle est nécessaire pour une impression de qualité. Le négatif (16) est ensuite placé sur la couche photopolymère, puis exposé au rayonnement UV (18), le film négatif joue alors le rôle d'un masque en laissant passer la lumière UV uniquement au travers des zones à imprimer (19a) et en laissant non-réticulées les zones cachées (19b). Après l'exposition, les parties non-réticulées sont éliminées par lavage et brossage avec des solvants appropriés, les parties réticulées restent alors en relief et forment ainsi le cliché imprimable.

La plaque photopolymère d'impression ainsi obtenue est ensuite montée sur un support d'impression (10), suivant les applications soit sur un cylindre d'impression, soit sur un manchon ou bien encore sur un tapis ou bande d'impression.

Le montage des plaques photopolymères d'impression se fait à l'aide de rubans adhésifs double-face (11). Suivant les applications, la technique peut varier. Soit l'utilisateur applique l'adhésif double face sur le support d'impression d'abord puis il vient appliquer la plaque photopolymère sur le double-face, soit il lamine le double-face directement sur la plaque.

L'utilisation de ces doubles-faces lors du montage pose plusieurs problèmes :

Il est effectivement très fréquent lors de ces différentes étapes de lamination de créer des bulles d'air au niveau des différentes interfaces (plaque - adhésif, support d'impression - adhésif). Ces bulles d'air lorsqu'elle ne sont pas détectées avant impression sont à l'origine de nombreux défauts d'impression.

Ces bulles d'air peuvent être éliminées à l'aide de seringues ou de cutters, mais cela se fait au détriment de la productivité et également de la plaque qui peut s'en trouver détériorée.

De plus l'utilisation de double-face pour le montage de plaques d'impression photopolymère de grande taille devient très difficile et très long ou bien nécessite des équipements de lamination très coûteux.

Pour résoudre ce problème, on connaît, dans l'état de la technique, des supports d'impression déjà dotés d'une couche adhésive réutilisable. Les plaques flexographiques pour l'impression sont fixées sur le support d'impression grâce au *tack* (propriété d'un adhésif à coller sans exercer une pression) de la couche adhésive. Entre deux utilisations de la même couche adhésive, celle-ci doit être nettoyée par une solution appropriée. Cette solution répond bien à une partie des limitations de l'utilisation des double-face en diminuant considérablement les bulles d'air entre l'adhésif et le support d'impression.

Cependant cette solution présente certains désavantages. Tout d'abord, le prix de ces manchons préadhésivés est très élevé et leur utilisation à la longue se révèle encore plus coûteuse. En effet, ils sont relativement fragiles et lorsque l'adhésif est légèrement détérioré par une manutention un peu brutale ou un coup de cutter, c'est le manchon dans son entier qu'il faut changer.

Cette solution nécessite également de réactiver le manchon sur toute sa surface pour pouvoir monter la plaque photopolymère en toute sécurité. Ceci a pour effet d'avoir une surface adhérence non recouverte importante susceptible de rentrer en contact avec le support à imprimer et/ou divers cylindres et ainsi de perturber considérablement l'impression. Cette partie réactivée non recouverte sera également plus facilement contaminée par la poussière ou des matériaux étrangers qui, à l'usage, rendront impossible une réutilisation.

L'art antérieur connaît également, par le brevet américain US 6 684 782, une plaque flexographique économique qui peut être montée sur une presse d'impression sans l'aide de ruban adhésif conventionnel. Cette plaque se prête à une utilisation répétée et permet une impression de haute précision. Le brevet concerne également une plaque flexographique et une planche originale pour cette dernière comprenant une couche de résine photopolymère, une couche de support isolante, une couche de liaison permettant de relier la couche de résine photopolymère et la couche de support, et une couche élastique. La couche de résine et la couche élastique sont disposées sur les faces externes tandis qu'une surface adhésive est disposée sur la surface avant de la couche élastique.

La solution propose donc une plaque transparente aux UV présentant sur la face inférieure une couche adhésive activable par une solution aqueuse ou un solvant.

Cette solution reste limitée en ce qu'elle nécessite une intervention manuelle humaine afin de réactiver la couche adhésive, l'utilisation d'un produit de réactivation qui se dégradera au fil des utilisations introduisant de ce fait une hétérogénéité dans les valeurs d'adhérences obtenues.

D'autre part la présence de la couche adhésive rend difficiles les manipulations plaque à plaque (par exemple lors de stockage sous forme de piles) à cause du *tack* résiduel de la couche adhésive.

La présence de cette couche adhésive à nu peut donner lieu à des réactivations non voulues de l'adhésif rendant très difficiles les manipulations et induisant une pollution par contamination qui, à la longue, altère les propriétés adhésives de la plaque photopolymère. Ces réactivations non voulues peuvent se produire lors de la fabrication de la plaque photopolymère et notamment au moment du nettoyage des parties non réticulées ou du séchage, la montée en température pouvant partiellement réactiver l'adhésif.

On connaît également, par le brevet américain US 5 753 414, une plaque d'impression constituée d'une couche support, d'une couche adhésive, d'un substrat et d'une couche photopolymère. La plaque d'impression peut être formée à partir d'un procédé dans lequel la résine photopolymère est enduite sur un substrat double-couche, la première couche est un film polymérique qui est en contact avec la couche photopolymère. La seconde couche est également un film polymérique. Un adhésif sensible à la pression PSA (*Pressure Sensitive Adhesive*) relie ces deux films entre eux. Lors du montage de la plaque, l'utilisateur enlève la couche pelable formée du second film polymérique et de la couche adhésive, la couche photopolymère et le premier film polymérique sont ensuite montés sur support d'impression à l'aide de rubans adhésifs double-face classiques. Cette solution nécessite donc toujours l'utilisation d'un ruban adhésif double-face pour le montage de la plaque photopolymère sur le support d'impression.

L'art antérieur présente donc des limitations dans la fabrication et le montage de plaques photopolymères. L'utilisation de rubans double-face ou d'adhésifs réutilisables occasionnent lors des différentes étapes de lamination la présence de bulles d'air dégradant la qualité de l'impression.

La présente invention entend remédier aux inconvénients de l'art antérieur en proposant un ruban adhésif multicouches transparent ou perméable à un rayonnement aux UV entrant comme support de couche photopolymère dans la réalisation de plaques photopolymères. L'invention vise à simplifier « considérablement » le processus de montage de ces plaques sur support d'impression.

La présente invention répond particulièrement bien aux attentes des imprimeurs de livres et des cartonniers qui désirent également améliorer leur productivité dans l'impression par exemple par flexographie. Le ruban adhésif selon l'invention, du fait de ses caractéristiques et performances, peut servir de couche support à la couche photopolymère, c'est-à-dire que ce ruban peut supporter et participer à tout le processus de fabrication des plaques photopolymères tout en apportant et en conservant la fonction adhésive nécessaire au montage de cette plaque sur le support d'impression.

Cela signifie que le ruban adhésif peut être découpé en formats, manipulé, enduit d'une couche photopolymère, soumis à un rayonnement UV sur ses deux faces (grâce à sa transparence, la réticulation dorsale est possible), tout en restant résistant à l'étape de nettoyage et brossage de la couche photopolymère non réticulée et de la phase de séchage final sans que les propriétés d'adhérence, de *tack* et de résistance au cisaillement (cohésion) de l'adhésif en soient altérées.

La présente invention concerne principalement un ruban adhésif transparent comprenant un film plastique, une couche adhésive et un film plastique pelable. Le film plastique présente une excellente stabilité dimensionnelle, il est suffisamment transparent et résistant aux UV et possède un primaire d'accrochage pour l'enduction ultérieure d'une couche photopolymère. La couche adhésive est du type adhésif sensible à la pression et également suffisamment transparente et résistante aux UV et possède toutes les caractéristiques adhésives nécessaires au montage de plaques photopolymère sur un support d'impression. Le film plastique pelable ou intercalaire joue le rôle de couche protectrice de l'adhésif sensible à la pression contre les agressions par contact durant tout le processus de préparation de la plaque photopolymère. Ce film pelable est laminé sur l'adhésif sensible à la pression et est également suffisamment transparent et résistant aux UV. Par sa propriété de pelabilité, le film peut s'ôter aisément lors du montage de la plaque.

Le ruban dans son ensemble doit également être suffisamment transparent et résistant aux UV A pour permettre la réticulation dorsale d'une résine photopolymère déposée sur le ruban.

À cet effet, l'invention concerne dans son acception la plus générale un ruban multicouches entrant dans la réalisation de plaques photopolymères du type comprenant une couche support dont la face inférieure est recouverte d'une couche adhésive, caractérisée en ce que
la face inférieure (32) est traiteé de sorte que la couche adhésive (5) soit parfaitement solidaire de la couche support (3)
- la couche support et la couche adhésive sont constituées de matériaux perméables à un rayonnement ;
- la face inférieure de la couche adhésive est munie d'un intercalaire pelable perméable au même rayonnement ;
- ladite couche adhésive comprend un adhésif sensible à la pression (PSA),
- ledit ruban multicouches (1) étant dépourvu d'une couche de résine photopolymère ou photopolymérisable sur une surface supérieure à 80 % de la surface du ruban.

De préférence, la face supérieure de la couche support a reçu un traitement apte à accrocher une résine photopolymère.

En particulier, le ruban selon l'invention est dépourvu d'une couche de résine photopolymère ou photopolymérisable, notamment du côté de la face supérieure (31) de la couche support (3), en particulier sur la face supérieure traitée (6) du ruban multicouche (1), sur une surface supérieure à 90 %, en particulier supérieure à 95 %, voire supérieure à 97,5 % de la surface du ruban, et tout particulièrement supérieure à 99 % de la surface du ruban. Avantageusement, le ruban est totalement dépourvu d'une couche de résine photopolymère ou photopolymérisable, notamment du côté de la face supérieure (31) de la couche support (3), et en particulier sur la face supérieure traitée (6) du ruban multicouche (1).

Selon un mode de réalisation, ledit ruban ne comprend pas de couche compressible ou élastique.

De préférence, ledit intercalaire comprend une couche anti-adhérente du type silicone, au contact de la face inférieure de la couche adhésive, et un film protecteur protégeant ladite couche anti-adhérente.

De préférence, ledit intercalaire présente une propriété antistatique pour permettre la manipulation feuille à feuille de ces plaques.

Selon un mode de réalisation, la face inférieure de la couche support en contact avec la couche adhésive a reçu un traitement TCA avant l'enduction de ladite couche adhésive.

Selon un mode de réalisation, ledit rayonnement est d'un type parmi les ultraviolets et le faisceau d'électrons.

Avantageusement, ladite couche support est un film polyester.

L'invention concerne également un procédé de montage d'une plaque photopolymère préparée à partir d'un ruban multicouches, sur un support d'impression, caractérisé en ce qu'il comprend les étapes suivantes :
- le pelage dudit intercalaire transparent du ruban multicouches ;
- l'apposition dudit ruban multicouches pelé de son intercalaire sur ledit support d'impression, le contact entre le ruban et la base étant réalisé par la couche adhésive.

On comprendra mieux l'invention à l'aide de la description, faite ci-après à titre purement explicatif, d'un mode de réalisation de l'invention, en référencé aux figures annexées :
- les figures 1 et 2 représentent l'état de l'art antérieur ;
- la figure 3 représente la composition d'un ruban selon la présente invention munie d'un intercalaire ;
- la figure 4 représente la structure d'une plaque photopolymère une fois finie.

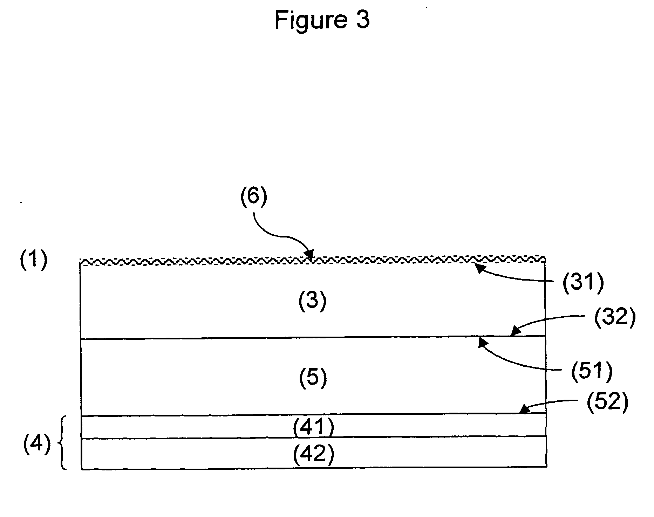

En référence à la figure 3, le ruban multicouches (1) selon l'invention présente une couche support de film plastique (3) stable dimensionnellement de manière à ne pas montrer d'élongation significative lors de l'application d'une tension et transparent ou perméable aux UV A de manière à permettre l'exposition dorsale. Cette perméabilité permet la propagation du rayonnement à travers les différentes couches afin de réticuler la résine photopolymère préalablement enduite sur le ruban. Les films plastiques de bonne stabilité dimensionnelle convenant à l'application peuvent être choisis parmi les films polyesters, polyacétate, polypropylènes orientés, polyamides. Outre sa stabilité dimensionnelle, ce film présente une souplesse ou flexibilité permettant la mise en bobine et en rouleaux tout en conservant sa planéité lorsque déplié ou la mise en application du ruban sur un support d'impression incurvé.

Idéalement, le film plastique (3) est un film polyester de type PET dont l'épaisseur varie entre 12 et 250 µm, de préférence 125 µm. Le PET 125 µm joue le rôle de support de couche photopolymère, cette couche (résine) pouvant être liquide ou solide. Il comporte donc à sa surface une couche adhésive ou primaire d'accroche (6) permettant une liaison très forte entre la couche photopolymère et le film PET 125 µm. Le traitement de surface est réalisé par enduction et doit être adapté à la nature de la résine déposée. Ce primaire d'accroche peut être un polymère ou copolymère transparent (par exemple, polyuréthane, acrylique, polybutadiène, ...) permettant une bonne liaison avec le film plastique (3). Ce primaire (6) peut également contenir des agents réactifs photosensibles afin de garantir une bonne liaison avec la résine photopolymère qui sera appliquée sur ce primaire. Ce traitement devant fournir, en définitive, une transparence suffisante pour permettre une exposition dorsale aux UV pendant l'étape de fabrication de la plaque d'impression sans que cela altère sa composition, et une propriété d'adhésion suffisante pour lier la résine photopolymère au film plastique support (3).

La face inférieure (32) du PET (3), destinée à recevoir une couche adhésive (5), est traitée de telle sorte que la couche adhésive soit parfaitement solidaire du PET pour permettre la repositionnabilité et l'enlevabilité de la plaque photopolymère sans transfert d'adhésif sur le support d'impression ou dépôt de résidus. On entend par repositionnabilité la possibilité de décoller aisément une plaque du support d'impression, suite à un mauvais positionnement de celle-ci, sans laisser de résidus et de la recoller sur le support sans altérer les propriétés d'adhésion de l'adhésif. L'enlevabilité concerne uniquement le retrait de la plaque, par exemple en fin d'impression, sans laisser de résidu de l'adhésif, résidu qu'il faudrait nettoyer avant d'appliquer une nouvelle plaque. Le traitement est, de préférence, réalisé par un réactif du type TCA (*Trichloroacetic Acid*), mais peut également être une enduction de primaire acrylate ou bien un traitement corona. Suivant la nature et la chimie de l'adhésif sensible à la pression PSA, un tel traitement peut s'avérer inutile. Quel que soit le choix de l'interface couche adhésive-PET (32-51), celle-ci doit rester suffisamment transparente aux UV A pour permettre la réticulation dorsale ultérieure de la couche photopolymère.

La couche adhésive (5) de la présente invention est, de préférence, réalisée dans un adhésif sensible à la pression aussi appelé adhésif PSA. Seule cette technologie permet d'avoir une surface présentant une adhésion permanente et immédiate, par opposition aux adhésifs réactivables de l'art antérieur qui nécessitent un apport de température ou autre moyen (solvant) ou par opposition aux colles qui demandent soit un temps d'attente pour l'évaporation des solvants avant fixation, soit une réticulation pour les colles structurales. Les adhésifs PSA présentent, en outre, les propriétés de repositionnabilité ou d'enlevabilité.

La chimie utilisée concerne principalement les adhésifs caoutchoucs, acryliques ou silicones, avec une utilisation de préférence des adhésifs caoutchoucs ou acrylique sous forme d'adhésif liquide transparent.

Cet adhésif est, de préférence, réticulé à l'aide de toute technique connue de l'homme du métier afin de favoriser l'enlèvement sans résidus et la résistance aux solvants utilisés lors du nettoyage de l'encre en fin d'impression.

L'épaisseur de la couche adhésive (5) est de 10 µm à 100 µm, de préférence entre 20 µm et 50 µm.

La technique d'enduction de l'adhésif permet, notamment, de se prévenir des bulles d'air mais surtout d'assurer une cohésion entre l'adhésif (5) et le PET (3) au travers du traitement TCA et d'éviter ainsi tout transfert d'adhésif sur le support d'impression lors de l'enlèvement.

Afin d'éviter tout décollement sur les bords de la plaque photopolymère, tout en conservant une bonne repositionnabilité et enlevabilité, l'adhérence à 90° de l'adhésif, mesuré par la méthode PSTC 2 devra être comprise entre 1 N/cm (Newton par centimètre) et 6 N/cm, de préférence entre 2 N/cm et 4 N/cm, le *tack* de l'adhésif mesuré par la méthode PSTC 6 doit être inférieur à 10 cm et de préférence inférieur à 5 cm.

Afin d'éviter tout déplacement de la plaque photopolymère sous les efforts de cisaillement subis par la plaque lors de l'impression, la résistance au cisaillement mesurée par la méthode AFERA 4012 (70°C - 25 mm * 25 mm - 1 kg) doit être de préférence supérieure à 24 heures.

Toujours en référence à la figure 3, un intercalaire transparent (4) est positionné sur la surface inférieure (52) de la couche adhésive (5). Cet intercalaire sert de protection à l'adhésif (5) pendant tout le processus de fabrication de la plaque photopolymère. Il est constitué d'un film plastique transparent aux UV (42) présentant une excellente stabilité dimensionnelle et d'une couche anti-adhérente transparente (41), solidaire de ce film plastique, en contact avec l'adhésif PSA (5).

Le film plastique (42) peut être réalisé dans les mêmes matériaux que la couche support (3) du ruban, par exemple un PET, et présente une épaisseur entre 23 et 100 µm. Son épaisseur doit permettre une bonne préhension de saisie et un bon amorçage dans le pelage de l'intercalaire, on préfèrera alors une épaisseur d'au moins 36 µm. Quant aux PET épais, le coût reste élevé, ce qui nous conduit à préférer une épaisseur maximale de film plastique de 75 µm.

La présence de la couche anti-adhérente (41) permet l'enlevabilité de l'intercalaire (4) : une résistance en pelage de l'intercalaire mesurée par la méthode PSTC 15 doit être comprise entre 1 N/cm et 10 N/cm de préférence entre 2 N/cm et 5 N/cm pour obtenir un bon compromis entre la facilité de pelage et la bonne tenue de l'intercalaire pendant les nombreuses manipulations que doit subir le ruban. Une telle couche anti-adhérente peut être réalisée en acrylique mais de préférence en silicone. L'intercalaire enlevable transparent doit être suffisamment résistant pour offrir une protection à l'adhésif durant toutes les opérations de conception et de manipulation. Il doit également permettre la réticulation de la résine par le dessous tout en s'enlevant aisément lorsque l'imprimeur souhaite monter sa plaque photopolymère préparée.

Dans un mode de réalisation qui répond particulièrement bien à l'automatisation et l'utilisation de machines qui prélèvent le ruban préalablement découpé en formats et stocké sur une pile, la surface externe de l'intercalaire (4) possède des propriétés antistatiques, soit par nature du matériau utilisé soit par traitement ultérieur contre l'électricité statique. Cela permet à la machine de prélever feuille par feuille le ruban (1).

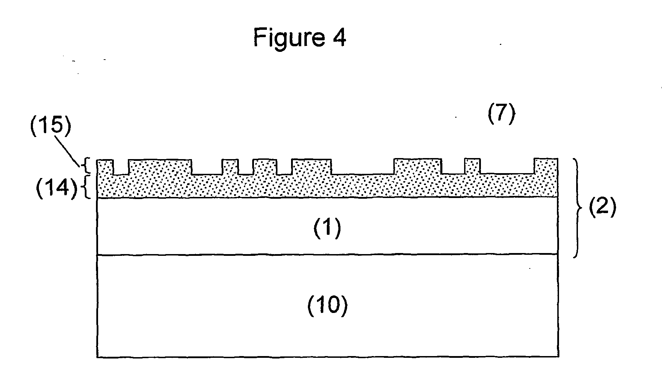

Le ruban décrit dans ce qui précède rentre dans l'élaboration de plaques photopolymères d'impression. En référence à la figure 4, un support d'impression (10), par exemple un PET d'épaisseur 250 µm ou une plaque métallique, accueille le ruban multicouches (1) débarrassé de son intercalaire (4) et sur lequel a été enduite et réticulée une résine photopolymère (7).

L'invention a encore pour objet un procédé de préparation de plaque photopolymère comprenant au moins une étape dans laquelle le ruban, notamment du côté de la face supérieure (31) de la couche support (3), et en particulier sur la face supérieure traitée (6) du ruban multicouche (1), est enduit d'une résine photopolymère ou photopolymérisable.

La préparation de la plaque photopolymère consiste à enduire une résine photopolymère liquide ou solide (7) sur la surface supérieure traitée (6) du ruban multicouches (1). Le traitement de cette surface assure une bonne tenue de cette résine.

Le ruban (1+7) est alors irradié aux UV A par-dessous l'intercalaire (irradiation dorsale) de telle sorte que la base de la résine (la partie mitoyenne avec le film PET (3)) réticule. Cette étape permet la création d'une semelle (14) de tenue de la résine sur le PET. Ensuite le négatif photographique représentant les motifs à imprimer est disposé sur la couche photopolymère, puis irradié au moyen d'un rayonnement aux ultraviolets A (UV A). Le nettoyage par solvant et le brossage de la résine permet de retirer l'excédent de résine non réticulée et de faire apparaître la forme des motifs (15) à imprimer (texte ou dessin).

La plaque photopolymère préadhésivée ainsi constituée est débarrassée de son intercalaire par pelage, puis apposée sur le support d'impression (10).

Le ruban selon la présente invention offre ainsi deux caractéristiques essentielles dans le cycle de préparation d'une impression : la diminution des bulles d'air entre les différentes couches de la plaque d'impression et le fait qu'il n'est désormais plus utile d'utiliser un adhésif double-face.

Las avantages induits sont multiples :
- une meilleure qualité d'impression due à l'absence ou au moins la très nette diminution de formation de bulles d'air,
- une diminution des coûts suite au gain de temps dans le processus de montage des plaques d'impression (retrait de l'étape de lamination du double-face, de l'étape de nettoyage de l'endos de la plaque avant apposition et de l'étape de vérification de la présence de bulles d'air et du perçage de celles-ci),
- une diminution de la dégradation et de la perte des plaques d'impression suite au perçage des bulles d'air qui altère ces plaques.

L'invention permet ainsi de travailler plus industriellement, c'est-à-dire en grande largeur, car actuellement la lamination manuelle du double-face sur les plaques se limite à de petites tailles, les grands formats sont laminés avec des machines très coûteuses en investissement. La présence de l'adhésif sur le ruban et donc la plaque d'impression préparée permet à de petits imprimeurs de passer à des grands formats sans investissement coûteux.

L'invention est décrite dans ce qui précède à titre d'exemple. Il est entendu que l'homme du métier est à même de réaliser différentes variantes de l'invention sans pour autant sortir du cadre du brevet.

## Revendications

1. Ruban multicouches (1) entrant dans la réalisation de plaques photopolymères (2) du type comprenant une couche support (3) dont la face inférieure (32) est recouverte d'une couche adhésive (5), **caractérisée en ce que**
- la face inférieure (32) est traitée de sorte que la couche adhésive (5) soit parfaitement solidaire de la couche support (3) ;
- la couche support (3) et la couche adhésive (5) sont constituées de matériaux perméables à un rayonnement ;
- la face inférieure (52) de la couche adhésive (5) est munie d'un intercalaire pelable (4) perméable au même rayonnement ;
- ladite couche adhésive (5) comprend un adhésif sensible à la pression (PSA),
ledit ruban multicouches (1) étant dépourvu d'une couche de résine photopolymère ou photopolymérisable sur une surface supérieure à 80 % de la surface du ruban.

2. Ruban multicouches (1) selon la revendication 1, **caractérisé en ce que** la face supérieure (31) de la couche support (3) a reçu un traitement (6) aptes à accrocher une résine photopolymère (7).

3. Ruban multicouches (1) selon la revendication 1 ou 2, **caractérisé en ce qu'**il est dépourvu d'une couche de résine photopolymère ou photopolymérisable, notamment du côté de la face supérieure (31) de la couche support (3), en particulier sur la face supérieure traitée (6) du ruban multicouche (1), sur une surface supérieure à 90 %, en particulier supérieure à 95 %, voire supérieure à 97,5 % de la surface du ruban, et tout particulièrement supérieure à 99 % de la surface du ruban.

4. Ruban multicouches (1) selon l'une quelconque des revendications précédentes, **caractérisé en ce qu'**il ne comprend pas de couche compressible ou élastique.

5. Ruban multicouches (1) selon l'une quelconque des revendications 1 à 4, **caractérisé en ce que** ledit intercalaire (4) comprend une couche anti-adhérente (41) du type silicone, au contact de la face inférieure (52) de la couche adhésive (5), et un film protecteur (42) protégeant ladite couche anti-adhérente.

6. Ruban multicouches (1) selon la revendication précédente, **caractérisé en ce que** ledit intercalaire (4) présente une propriété antistatique pour permettre la manipulation feuille à feuille de ces plaques.

7. Ruban multicouches (1) selon l'une quelconque des revendications précédentes, **caractérisé en ce que** la face inférieure (32) de la couche support en contact avec la couche adhésive (5) a reçu un traitement TCA avant l'enduction de ladite couche adhésive (5).

8. Ruban multicouches (1) selon l'une quelconque des revendications précédentes, **caractérisé en ce que** ledit rayonnement est d'un type parmi les ultraviolets et le faisceau d'électrons.

9. Ruban multicouches (1) selon l'une quelconque des revendications précédentes, **caractérisé en ce que** ladite couche support (3) est un film polyester.

10. Procédé de montage d'une plaque photopolymère préparée à partir d'un ruban multicouches (1) selon la revendication 3, sur un support d'impression (10), **caractérisé en ce qu'**il comprend les étapes suivantes :
- le pelage dudit intercalaire transparent (4) du ruban multicouches (1) ;
- l'apposition dudit ruban multicouches (1) pelé de son intercalaire sur ledit support d'impression (30), le contact entre le ruban et la base étant réalisé par la couche adhésive (5).

## Claims

1. Multi-layer ribbon (1) used in the production of photopolymer plates (2) of the type comprising a support layer (3) wherein the bottom face (32) is coated with an adhesive layer (5), **characterised in that**
- the bottom face (32) is treated such that the adhesive layer (5) is perfectly attached to the support layer (3);
- the support layer (3) and the adhesive layer (5) are constituted by radiation-permeable materials;
- the bottom face (52) of the adhesive layer (5) comprises a peel-off insert (4) permeable to the same radiation;
- said adhesive layer (5) comprises a pressure-sensitive adhesive (PSA),
said multi-layer ribbon (1) being devoid of a photopolymer or photopolymerisable resin layer on a surface area greater than 80% of the surface area of the ribbon.

2. Multi-layer ribbon (1) according to claim 1, **characterised in that** the top face (31) of the support layer (3) has received a treatment (6) suitable for adhering a photopolymer resin (7).

3. Multi-layer ribbon (1) according to claim 1 or 2, **characterised in that** it is devoid of a photopolymer or photopolymerisable resin layer, particularly on the side of the top face (31) of the support layer (3), particularly on the treated top face (6) of the multi-layer ribbon (1), on a surface area greater than 90%, particularly greater than 95%, or greater than 97.5% of the surface area of the ribbon, and more particularly greater than 99% of the surface area of the ribbon.

4. Multi-layer ribbon (1) according to any of the above claims, **characterised in that** it does not comprise a compressible or elastic layer.

5. Multi-layer ribbon (1) according to any of claims 1 to 4, **characterised in that** said insert (4) comprises an anti-adherent layer (41) of the silicone type, in contact with the bottom face (52) of the adhesive layer (5), and a protective film (42) protecting said anti-adherent layer.

6. Multi-layer ribbon (1) according to the above claim, **characterised in that** said insert (4) has an antistatic property to enable sheet by sheet handling of these plates.

7. Multi-layer ribbon (1) according to any of the above claims, **characterised in that** the bottom face (32) of the support layer in contact with the adhesive layer (5) has received a TCA treatment before the coating of said adhesive layer (5).

8. Multi-layer ribbon (1) according to any of the above claims, **characterised in that** said radiation is of a type including ultraviolet and electron beams.

9. Multi-layer ribbon (1) according to any of the above claims, **characterised in that** said support layer (3) is a polyester film.

10. Method to assemble a photopolymer plate prepared from a multi-layer ribbon (1) according to claim 3, on a printing support (10), **characterised in that** it comprises the following steps:
- peeling said transparent insert (4) off of the multi-layer ribbon (1);
- placing said multi-layer ribbon (1) peeled off the insert thereof on said printing support (30), the contact between the ribbon and the base being carried out by the adhesive layer (5).

## Patentansprüche

1. Mehrschichtenband (1) als Bestandteil der Realisierung von Fotopolymerplatten (2) des Typs umfassend eine Trägerschicht (3), deren Unterseite (32) mit einer Haftschicht (5) überzogen ist, **dadurch gekennzeichnet, dass**
- die Unterseite (32) derart behandelt ist, dass die Haftschicht (5) einwandfrei mit der Trägerschicht (3) verbunden ist;
- die Trägerschicht (3) und die Haftschicht (5) sich aus Materialien zusammensetzen, die hinsichtlich einer Strahlung durchlässig sind;
- die Unterseite (52) der Haftschicht (5) mit einer abziehbaren Einlage (4) ausgestattet ist, die hinsichtlich derselben Strahlung durchlässig ist;
- die genannte Haftschicht (5) einen druckempfindlichen Kleber (PSA) umfasst,
wobei das genannte Mehrschichtenband (1) nicht mit einer Schicht aus Fotopolymerharz oder fotopolymerisierbarem Harz über eine Fläche von mehr als 80% der Fläche des Bandes versehen ist.

2. Mehrschichtenband (1) nach Anspruch 1, **dadurch gekennzeichnet, dass** die Oberseite (31) der Trägerschicht (3) eine Behandlung (6) erhalten hat, die dazu geeignet ist, ein Fotopolymerharz (7) zu erfassen.

3. Mehrschichtenband (1) nach Anspruch 1 oder 2, **dadurch gekennzeichnet, dass** es nicht mit einer Schicht aus Fotopolymerharz oder fotopolymerisierbarem Harz versehen ist, namentlich an der Seite der Oberseite (31) von der Trägerschicht (3), besonders an der behandelten Oberseite (6) des Mehrschichtenbandes (1), über eine Fläche von mehr als 90%, insbesondere von mehr als 95%, oder gar von mehr als 97,5% von der Fläche des Bandes, und ganz besonders von mehr als 99% der Fläche des Bandes.

4. Mehrschichtenband (1) nach einem der vorhergehenden Ansprüche, **dadurch gekennzeichnet, dass** es keine verdichtbare oder elastische Schicht umfasst.

5. Mehrschichtenband (1) nach einem der Ansprüche 1 bis 4, **dadurch gekennzeichnet, dass** die genannte Einlage (4) eine Antihaftschicht (41) des Typs Silikon, die im Kontakt mit der Unterseite (52) der Haftschicht (5) steht, und eine Schutzfolie (42), die die genannte Antihaftschicht schützt, umfasst.

6. Mehrschichtenband (1) nach dem vorhergehenden Anspruch, **dadurch gekennzeichnet, dass** die genannte Einlage (4) eine antistatische Eigenschaft aufweist, um die Blatt-für-Blatt-Handhabung dieser Platten zu erlauben.

7. Mehrschichtenband (1) nach einem der vorhergehenden Ansprüche, **dadurch gekennzeichnet, dass** die Unterseite (32) der Trägerschicht im Kontakt mit der Haftschicht (5) eine TCA-Behandlung vor der Beschichtung der genannten Haftschicht (5) erhalten hat.

8. Mehrschichtenband (1) nach einem der vorhergehenden Ansprüche, **dadurch gekennzeichnet, dass** die genannte Strahlung eines Typs zwischen Ultraviolett und Elektronenstrahl ist.

9. Mehrschichtenband (1) nach einem der vorhergehenden Ansprüche, **dadurch gekennzeichnet, dass** die genannte Trägerschicht (3) eine Polyesterfolie ist.

10. Montageverfahren einer Fotopolymerplatte, die nach Anspruch 3 anhand eines Mehrschichtenbandes (1) auf einem Druckträger (10) vorbereitet ist, **dadurch gekennzeichnet, dass** es folgende Schritte umfasst:
- das Abziehen der genannten transparenten Einlage (4) vom Mehrschichtenband (1);
- das Anbringen des genannten Mehrschichtenbandes (1), abgezogen von seiner Einlage auf dem genannten Druckträger (30), wobei der Kontakt zwischen dem Band und der Basis durch die Haftschicht (5) realisiert wird.
